# EUROPÄISCHE PATENTSCHRIFT

(11) **EP 2 718 481 B1**
(45) Veröffentlichungstag und Bekanntmachung des Hinweises auf die Patenterteilung: **05.04.2017**
(21) Anmeldenummer: 12725315.1
(22) Anmeldetag: 31.05.2012
(51) Int. Cl.: C23G 5/00

(54) **ENTSCHICHTUNGSVERFAHREN FÜR HARTE KOHLENSTOFFSCHICHTEN**
METHOD FOR REMOVING HARD CARBON LAYERS
PROCÉDÉ D'ENLÈVEMENT DE COUCHES DE CARBONE DURES

(30) Priorität: 07.06.2011 DE 102011105645
(43) Veröffentlichungstag der Anmeldung: 16.04.2014
(73) Patentinhaber: Oerlikon Surface Solutions AG, Pfäffikon, 8808 Pfäffikon (CH)
(72) Erfinder: RAMM, Jürgen, CH-7304 Maienfeld (CH); WIDRIG, Beno, CH-7310 Bad Ragaz (CH)
(74) Vertreter: Kempkens, Anke
(86) Internationale Anmeldenummer: PCT/EP2012/002305
(87) Internationale Veröffentlichungsnummer: WO 2012/167886

(56) Entgegenhaltungen:
- EP-A1- 0 510 340
- EP-A2- 2 180 499
- US-A- 5 993 680
- CASTANEDA S I ET AL: "Surface modifications in diamond-like carbon films submitted to low-energy nitrogen ion bombardment", NUCLEAR INSTRUMENTS & METHODS IN PHYSICS RESEARCH, SECTION - B:BEAM INTERACTIONS WITH MATERIALS AND ATOMS, ELSEVIER, AMSTERDAM, NL, Bd. 175-177, 1. April 2001 (2001-04-01), Seiten 699-704, XP004242723, ISSN: 0168-583X, DOI: 10.1016/S0168-583X(00)00562-0
- TANOUE H ET AL: "Removal of Diamond-like Carbon Film by Oxygen-dominated Plasma Beam Converted from Filtered Carbon-cathodic Arc", JAPANESE JOURNAL OF APPLIED PHYSICS JAPAN SOCEITY OF APPLIED PHYSICS JAPAN, Bd. 50, Nr. 1, Januar 2011 (2011-01), XP002683588, ISSN: 0021-4922

## Beschreibung

Die vorliegende Erfindung betrifft ein Verfahren zum Entschichten von Kohlenstoffschichten bzw. Kohlenstoffbeschichtungen, insbesondere von ta-C Schichten von Substratoberflächen von Werkzeugen und Bauteilen. Das Verfahren erlaubt eine vereinfachte und industrietaugliche Verarbeitung von solchen Substraten in großen Mengen, wobei das Verfahren in der gleichen Vakuumkammer durchgeführt werden kann in der die entschichteten Substrate wieder beschichtet werden können. Das Verfahren gemäß der vorliegenden Erfindung dient insbesondere zum gewerblichen Entschichten von ta-C-Schichten von teuren Werkzeugen und Bauteilen zum Zwecke der Wiederbeschichtung. Das Verfahren ist besonders vorteilhaft anwendbar bei Substraten, die Oberflächen mit scharfen Kanten und/oder komplexen Geometrien aufweisen.

### Beschichtung und Entschichtung von Oberflächen

Es ist Stand der Technik, Werkzeuge und Bauteile mit dünnen Schichten zu versehen, um ihre Eigenschaften, beispielsweise bezüglich des Verschleißes, zu verbessern. Hartstoffschichten zum Verschleißschutz von Bauteil- und Werkzeugoberflächen werden üblicherweise mit Schichtdicken von mindestens 0.1 µm abgeschieden. In vielen Bereichen werden diese Werkzeuge und Bauteile aus teuren Materialien hergestellt und der Herstellungsprozess ist sehr aufwendig. Das ist der Grund, weshalb bei der Entwicklung von Schichten und Beschichtungsprozessen auch schon an die Entwicklung von geeigneten Entschichtungsverfahren gedacht werden muss.

Ein geeignetes Entschichtungsverfahren soll grundsätzlich ein vollständiges Entfernen der Beschichtung von der Substratoberfläche ermöglichen, ohne dass dies zu Schäden an der Substratoberfläche oder zu Änderungen der Substratgeometrie führt. Dadurch soll eine Wiederbeschichtung und Wiederverwendung eines entschichteten Werkzeugs oder Bauteils möglich werden, was sowohl die Kosten reduzieren hilft und zur besseren Ausnutzung der natürlichen Ressourcen beiträgt.

### Kohlenstoffschichten

Kohlenstoffschichten werden in Sinne der vorliegenden Erfindung wie folgt definiert:

Kohlenstoffschichten sind dünne Schichten, die überwiegend aus dem chemischen Element Kohlenstoff bestehen. Dazu zählen die Plasmapolymerschichten, die amorphen, diamantähnlichen Kohlenstoffschichten (DLC, engl. diamond-like carbon), die CVD-Diamantschichten sowie die Graphitschichten. Mit Beschichtungen aus Kohlenstoff lassen sich vielfältige Oberflächenfunktionen realisieren, vor allem im Bereich der Tribologie bzw. in Anwendungen, die auf den ganzen Bereich des Verschleißschutzes abzielen, also beispielsweise für Zerspanungswerkzeuge, Werkzeuge zum Stanzen und Formen, aber auch zum Schutz von Bauteilen.

Graphitschichten sind Kohlenstoffschichten, die ausschließlich aus sp²-hybridisierten Kohlenstoffatomen bestehen. Sie finden beispielweise auf Scheibenbremsen an Flugzeugen, als Beschichtungen von Heiz- oder Brennelementen oder, aufgrund ihrer Biokompatibilität, in vielen Biomedizinischen Artikeln wie Implantaten Verwendung.

Diamantschichten sind Kohlenstoffschichten mit maximalem Verschleißwiderstand. Überlappen sich die sp³-Orbitale von Atomen, können sie feste kovalente Bindungen bilden, die dann die tetraedrische Struktur aufweisen. Sie bilden das Grundgerüst des Diamantgitters. Sie lassen sich üblicherweise durch spezielle chemische Gasphasenabscheideverfahren herstellen. Dabei entstehen mikro- oder nanokristalline Schichten, die durch gezieltes Verändern der Prozessparameter texturiert werden können und so einen äußerst geringen Reibwert und Verschleiß aufweisen.

Amorphe oder Röntgenamorphe Kohlenstoffschichten, die unter der Bezeichnung DLC-Schichten als diamantähnliche Kohlenstoffschichten bekannt sind, werden nach VDI 2840 wie folgt eingeteilt:
- Wasserstofffreie amorphe Kohlenstoffschichten, a-C, bestehen überwiegend aus sp²-hybridisierten Bindungen und werden deshalb auch als graphitartige Kohlenstoffschichten bezeichnet.
- Tetraedrische wasserstofffreie amorphe Kohlenstoffschichten, ta-C, sind vollständig amorph, d. h. sie haben keine erkennbare kristalline Struktur. Diese Schichten bestehen überwiegend aus sp³-hybridisierten Bindungen, weshalb sie den Diamantschichten gleichzusetzen sind.
- Metallhaltige wasserstofffreie amorphe Kohlenstoffschichten, a-C:Me, bestehen überwiegend aus sp²-hybridisierten Bindungen.
- Wasserstoffhaltige amorphe Kohlenstoffschichten, a-C:H, bestehen aus sp²- und sp³-hybridisierten Bindungen.
- Tetraedrische wasserstoffhaltige amorphe Kohlenstoffschichten, ta-C:H mit überwiegend sp³-hybridisierten Kohlenstoffatomen.
- Metallhaltige wasserstoffhaltige amorphe Kohlenstoffschichten, a-C:H:Me mit überwiegend sp²-hybridisierten Kohlenstoffatomen.
- Mit Nichtmetallen modifizierte wasserstoffhaltige amorphe Kohlenstoffschichten, a-C:H:X (X = Si, O, N, F, B, ...) mit überwiegend sp³-hybridisierten Kohlenstoffatomen.

### Die Entschichtungsproblematik bei ta-C Schichten

Die ta-C Schichten besitzen Härten bis zu 85 GPa und sind deshalb den herkömmlichen mit plasmaunterstütztem CVD abgeschiedenen diamantartigen Kohlenstoffschichten mit Wasserstoffanteilen bis zu 30 at. % deutlich überlegen, vor allem bezüglich Schichthärte und Temperaturstabilität. Der Anteil an tetraedrischen diamantartigen Bindungen in ta-C Schichten (von bis zu 85 %) ist der bestimmende Parameter für die besonders hohe Härte dieser Schichten.

ta-C Schichten können durch verschiedene Prozesse hergestellt werden. Bevorzugt werden jedoch Laserpulsabscheidungsprozesse (siehe z.B. den Bericht über Forschung an Fachhochschulen, der im Jahr 2006 durch das deutsche Bundesministerium für Bildung und Forschung herausgegeben wurde, Seiten 21-22) und kathodische Funkenverdampfungsprozesse (siehe z.B. US6331332, EP0652301, US20070187229 und EP0666335).

Mögliche Einsatzgebiete für ta-C-Schichten sind Bauteile und Maschinenelemente im Automobil-, Werkzeug- und Maschinenbau, die eine superharte Oberflächenbeschichtung benötigen (Quelle: Bericht über Forschung an Fachhochschulen, den im Jahr 2006 durch das deutsche Bundesministerium für Bildung und Forschung herausgegeben wurde, Seiten 21-22). Im Bereich der Werkzeugbeschichtungen finden ta-C Schichten besonders bei Zerspanungswerkzeugen für A1 und Al-Legierungen, für Cu sowie Edelmetallen Anwendung. Vielversprechendes Anwendungspotential existiert auch für Form- und Stanzwerkzeuge.

Trotz der sehr interessanten Eigenschaften der ta-C-Schichten konnten sich diese bisher nur in kleineren Marksegmenten etablieren. Eine Problematik bei der Anwendung von ta-C Schichten ist ihre unzureichende Schichthaftung auf einigen Materialien (wie z.B. auf verschiedene Stahlsorten und vor allem bei größeren ta-C-Schichtdicken bzw. ≥ 1 µm), die grundsätzlich auf ihre sehr hohen Schichteigenspannungen zurückzuführen ist. Hinzu kommt, dass die Synthese dieser ta-C Schichten bei niedrigen Substrattemperaturen (T_{S}) von typischerweise kleiner 150 °C stattfinden sollte, damit ihre charakteristisch hohe Schichthärte erreicht wird. Das bedeutet, dass die oft verwendeten Heiz- und Ätzprozesse, die zur Vorbehandlung zum Zwecke der verbesserten Schichthaftung durchgeführt werden, wegfallen oder stark verkürzt angewendet werden, weil diese zu höheren Substrattemperaturen führen würden.

Aus diesen Gründen wird das Metallionenätzen (MIE: metal ion etching) als Vorbehandlungsprozess für die Verbesserung der Schichthaftung von ta-C-Schichten angewendet. Das Metallionenätzen wird so ausgeführt, dass die Substratoberflächen mit Metallionen (beispielsweise mit Cr-Ionen) beschossen wird, aber gerade so, dass es zu keinem nennenswerten metallischem Schichtwachstum kommt, d.h. dass auch kein metallisches Interface zwischen Substrat und Schicht entsteht. Gut haftende harte ta-C-Schichten weisen deshalb in der Regel praktisch kein oder nur ein sehr dünnes metallisches Interface auf. Da das allgemein verwendete nasschemische Entschichten darauf beruht, dass ein metallisches Interface angegriffen und entfernt wird (und damit auch die Schicht), stellen ta-C Schichten in Bezug auf das Entschichten ein bisher ungelöstes Problem dar.

### Stand der Technik

Mehrere Entschichtungsverfahren zum Entfernen von Hartstoffschichtsystemen, die beispielweise mit galvanischen, PVD- oder CVD-Verfahren auf verschiedene Oberflächen aufgebracht wurden, sind heute aus dem Stand der Technik bekannt.

Aus WO2005073433, WO2009132758 und EP1725700 sind zum Beispiel einige nasschemischen Verfahren zum Entschichten bekannt geworden, die aber (wie schon oben erwähnt) das Vorhandensein einer metallischen Zwischenschicht zwischen dem Substrat und der Beschichtung voraussetzten.

Auch mechanische Verfahren werden oft als Entschichtungsverfahren verwendet. In JP2003200350 ist zum Beispiel ein mechanisches Verfahren zum Entschichten von Hartkohlenstoffschichtsystemen offenbart. Es handelt sich um ein Strahlverfahren mittels Feststoff. Als Strahlgranulat wird ein feinkörniges abrasives Pulver angewendet (z.B. feinkörniges Aluminiumoxid- oder feinkörniges Diamantpulver) und Luft als Trägermedium. Durch den Aufprall des abrasiven Strahlmediums auf das beschichtete Substrat wird die Hartkohlenstoffbeschichtung entfernt.

Laserstrahlen können auch zur Stofftrennung angewendet werden so wie es in DE19831914 offenbart ist.

Auch kombinierte Verfahren können zum Entfernen von korrosionsbeständigen Schutzschichten und Polymerrückständen von Substraten (z.B. Halbleiterscheiben) verwendet werden, wie es zum Beispiel in CN101308764 gezeigt wird. Das dort beschriebene Entschichtungsverfahren kombiniert Ätzverfahren mit nasschemischen Verfahren, wobei das beschichtete Substrat zuerst in einer Vakuumkammer geätzt und anschließend in eine Entschichtungskammer gebracht wird, um die korrosionsbeständige Schutzschicht zu entfernen, und abschließend wieder in die Vakuumkammer gebracht wird, um zum zweiten Mal geätzt zu werden.

EP2180499 offenbart ein Verfahren zum substratschonenden Entfernen von Hartstoffschichten von einem Substrat, insbesondere von Kohlenstoffschichten von Werkzeugoberflächen, sowie eine Vorrichtung zur Durchführung des Verfahrens. Das dort offenbarte Entschichtungsverfahren wird durch eine Niederspannungsplasmaentladung mit Entladespannungen von 250 V bis 1000 V unterstützt, wobei die Niederspannungsplasmaentladung mit Hilfe eines NF-Generators mit Pulsfrequenzen im Bereich von 20 bis 60 kHz erzeugt wird.

In EP0510340 wurde ein Wasserstoffplasmaverfahren zur Abtragung von Material von Substratoberflächen von z.B. Werkzeugen oder Halbleitern in einer Vakuumkammer offenbart, die später in einem Vakuumverfahren beschichtet werden. Mit Abtragung von Material von Oberflächen ist aber in EP0510340 nur die Reinigung der Oberfläche von Substraten gemeint, wobei nur sehr dünne Schichten bzw. Schichten mit Schichtdicken von ca. 10 nm in Frage kommen. Im Reinigungsverfahren in EP0510340 wird eine Niedervoltbogenentladung zur Anregung des Reaktivgases bzw. Wasserstoffgases verwendet. Die Autoren haben über Plasmaspannungswerte von bis 55 V berichtet.

In US6902774 wurde ein Plasmaverfahren zur Behandlung von Substratoberflächen offenbart, das Teil eines Konfektionierungsprozesses von integrierten Schaltungen ist, wobei ein Wasserstoff-, oder ein Stickstoff- oder ein Wasserstoff-Stickstoff-Plasma verwendet wird, um die Substratoberfläche mit Wasserstoff und/oder Stickstoff anzureichern und dadurch die Eignung der behandelten Substratoberfläche für ein nachträgliches Bonden oder Kleben langzeitig zu konservieren, obwohl die behandelte Substratoberfläche direkt nach der Plasmabehandlung bzw. vor dem Bonden oder Kleben während langer Zeit in einer Luftatmosphäre gelagert wird. Zur Anregung des Reaktivgases wird die Verwendung einer Niederspannungsplasmaentladung mit Entladespannungen von 10 V bis 100 V empfohlen, damit Temperaturbelastungen am Substrat minimiert werden.

### Problematik

Zum erfolgreichen Einsatz eines nasschemischen Verfahrens zum Entschichten von ta-C Schichten, wäre wie oben erwähnt, die Existenz von mindestens einer metallischen Schicht als Interface zwischen der ta-C Schicht und dem Substrat erforderlich. Wie bereits erläutert, müssen aber für eine zufriedenstellende Schichthaftung von ta-C Schichten auf beispielsweise weichen Stahlsubstraten optimierte MIE-Vorbehandlungen durchgeführt werden, die kein oder ein zu dünnes metallisches Interface aufweisen, um solche Verfahren anwenden zu können. Zudem bedingen solche chemischen Verfahren eine von der Beschichtung abweichende Infrastruktur und verursachen hohe Kosten bei der umweltfreundlichen Entsorgung der Restchemikalien.

Den Einsatz von mechanischen Verfahren, wie das oben beschriebene Strahlverfahren zum Entschichten von Hartkohlenstoffschichtsystemen wird oft für das Entschichten von diamantähnlichen und Diamantbeschichtungen verwendet. Dennoch sind mechanische Verfahren nicht so gut geeignet bzw. nicht günstig, wenn teure Substrate mit scharfen Kanten und/oder komplizierten Geometrien entschichtet werden müssen, weil durch diese Art von Behandlungen unerwünschte Verformungen des Schneidwinkels (bei Zerspanungswerkzeugen oder Stanzwerkzeugen) oder überhaupt der Substratgeometrie entstehen. Zudem werden durch eine solche Behandlung häufig unerwünschte Eigenspannungen im einschichteten Substrat erzeugt. Ferner kann der Aufwand hinsichtlich des benötigten Substrathalterungssystems groß sein, wenn es um die Entschichtung von Substraten mit komplizierten Geometrien geht. In Extremfällen müsste jedes Substrat einzeln ausgerichtet, gehaltert und eventuell sogar in einer besonderer Art und Weise bewegt werden, um eine optimale Verteilung der auf die Substratoberfläche auftretenden Kräfte zu gewährleisten.

Demzufolge kommen nach der Ansicht der Erfinder vorzugsweise plasmaunterstützte Verfahren zum Entschichten von ta-C Schichten in Frage.

Bei dem plasmaunterstützten Verfahren zum substratschonenden Entfernen von Hartstoffschichten von einem Substrat gemäß EP2180499 (bereits oben erwähnt) wird das zu entschichtende Substrat auf einen Substrathalter in einer Vakuumkammer zwischen zwei Wandantennen angeordnet, die Vakuumkammer wird mit einem den Abtransport von Kohlenstoff in Gasform unterstützenden Reaktivgas beschickt, an die beiden Antennen und ggf. den Substrathalter wird mithilfe eines NF-Generators (NF: Niederfrequenz) eine gepulste Spannung von 250 bis 1000 V bei 20 bis 60 kHz angelegt, und abschließend wird das Substrat mit dem Plasma über eine hinreichend lange Zeit beaufschlagt.

Die Autoren von EP2180499 weisen darauf hin, dass mit dem offenbarten Verfahren Kohlenstoffschichten jeglicher Art entfernt werden können bzw. neben amorphen Kohlenstoff und Graphit auch Diamant und insbesondere auch DLC-Schichten mit wechselndem bis hohem Anteil an sp³-hybridisiertem Kohlenstoff.

Ferner offenbaren die Autoren von EP2180499, dass die Entschichtung des Substrats in Gegenwart eines mit Kohlenstoff reaktiven Gases durchgeführt wird. Die Autoren erwähnen, dass als solche reaktive Gase insbesondere Sauerstoff und sauerstoffhaltige Gase jeglicher Provenienz, Wasserstoff und wasserstoffhaltige Mischgase, sowie Halogene in Form von weniger korrosiven Halogenverbindungen (wie z.B. Halogenverbindungen mit Stickstoff und Kohlenstoff (NF₃, CF₄, C₂F₆, CH₂F₂), Pseudohalogenverbindungen (wie z.B. HCN, (CN)₂) und Stickoxide (wie z.B. N₂O, NO) in Frage kommen.

Zusätzlich sind in EP2180499 Beispiele angegeben worden, bei denen DLC- und Diamantschichten von temperaturempfindlichen Substraten bei Temperaturen von 100-250 °C entschichtet wurden. Als Reaktivgas wurde Sauerstoff angewendet. Wasserstoffhaltige DLC-Schichten wurden zum Beispiel mit Hilfe von sowohl bipolar angeregten Plasmen als auch unipolar angeregten Plasmen (gepulsten Gleichspannungsplasmaentladungen) bei Entladespannungen von 500-900 V und Anregungsfrequenzen von 30-40 kHz entschichtet. Die Entschichtungszeit war schichtdicken- und pulsmodulierungsabhängig. Diamantschichten wurden zum Beispiel mit Hilfe eines unipolar angeregten Plasmas bei einer Entladespannung von 800 V und einer Anregungsfrequenz von 40 kHz entschichtet. Die Entschichtungszeit war zwischen 14 und 20 h. Außerdem wurde in EP2180499 hingewiesen, dass die entschichteten Substrate direkt anschließend bei einem gleichbleibenden Arbeitsdruck mit einem Wasserstoffplasma (z.B. auch mit einem Wasserstoff-Argon-Plasma) weiter gereinigt werden können, um Verfärbungen der Substrate nach der Entschichtungsbehandlung zu entfernen.

Zum gewerblichen Entschichten von ta-C Schichten von Bauteilen und Werkzeugen hat das in EP2180499 beschriebene Verfahren hauptsächlich folgende Nachteile:
- NF-Generatoren, die hohe Leistungen in ein Plasma einspeisen müssen und mit der Möglichkeit zum unipolaren und/oder bipolaren Betrieb sind wesentlich teurer als einfache DC-Generatoren. Die Störanfälligkeit von NF-Generatoren ist höher, besonders wenn der Plasmabetrieb für sehr unterschiedliche Beladungen der Systeme realisiert werden soll und keine weiteren Anpassungen gemacht werden sollen.
- Das benötigte Antennensystem zur Erzeugung des Plasmas zum Entschichten lässt sich häufig nicht günstig und problemlos in konventionelle Beschichtungsanlagen integrieren und deshalb kann unter Umständen die Verwendung dieses Verfahrens an eine neue Anlage gebunden sein.

- Die beschriebene Antennenkonfiguration erzeugt in aller Regel Sputterplasmen. Diese Art von Plasmen ist durch eine relativ niedrige Stromdichte charakterisiert, die entsprechend auf eine relativ niedrige Elektronendichte hinweisen.
- Weil die Antennen im Plasma eintauchen, ist es möglich, dass das Antennenmaterial abgesputtert wird und das abgesputterte Material die Substratoberfläche verunreinigt. Eine solche Verunreinigung der Oberfläche ist sehr problematisch für die Schichthaftung von ta-C Schichten bei der Wiederbeschichtung.
- Die Entschichtungszeiten zum Entschichten von Diamantschichten mit häufig gebrauchten Schichtdicken sind sehr lang (ca. 14 bis 20 h) im Vergleich zu den berichteten Entschichtungszeiten beim Entschichten von DLC-Schichten mit häufig gebrauchten Schichtdicken (ca. 1 h). Das lässt sich durch die viel höhere chemische und thermische Stabilität von Diamantschichten erklären. Aufgrund des sehr hohen Anteils von sp³-hybridisierten Bindungen bzw. von tetraedrischen diamantartigen Bindungen in ta-C Schichten (∼85 %) und dem fehlenden Wasserstoffeinbau in die Schicht, kann man bei der Verwendung dieses Verfahren für das Entschichten von ta-C Schichten bei den üblichen Schichtdicken sehr lange Entschichtungszeiten erwarten (theoretisch mindestens ca. 12 bis 17 h). Das spricht aber gegen die Industrietauglichkeit dieses Verfahrens zum Entschichten von ta-C Schichten, weil längere Entschichtungszeiten unbedingt mit schlechter Wirtschaftlichkeit verbunden sind.
- Das Plasmaentschichten mit Sauerstoff oder mit einem sauerstoffhaltigen Gas als Reaktivgas bewirkt auch ungewünschte Oxidationsverfahren der Oberfläche von metallischen Substraten. Die davon resultierenden dünnen Oxidschichten müssen dann später z.B. mit wasserstoffhaltigen Plasmen weggeätzt werden.
- Durch die Verwendung von Sauerstoff wird nicht nur die Substratoberfläche oxidiert, sondern auch die Antennenoberfläche und daher kann es zu Veränderungen der Plasmaentschichtungsparameter während des Entschichtungsprozesses kommen, d.h. es kann sich die Stromdichte und folglich die Elektronendichte im Plasma während des Entschichtungsprozesses ändern, d.h. der Prozess ist schwer kontrollierbar.

### Aufgabenstellung

Der vorliegenden Erfindung liegt die Aufgabe zugrunde, gegenüber dem Stand der Technik Verbesserung zu schaffen durch ein industrietaugliches Verfahren zum Entschichten von Kohlenstoffbeschichtungen, insbesondere von CVD- und/oder PVD- abgeschiedene Kohlenstoffschichten (CVD: chemical vapour deposition bzw. chemische Gasphasenabscheidung, PVD: physical vapor deposition bzw. physikalische Gasphasenabscheidung). Speziell soll das Verfahren ein industrietaugliches Verfahren zum Entfernen von ta-C Schichten von jeder Art von Substraten zu gewährleisten. Das Verfahren soll ferner die schnelle Verarbeitung von Substraten in großen Mengen erlauben. Bevorzugt soll das erfindungsgemäße Verfahren in der gleichen Vakuumkammer stattfinden, in welcher die entschichteten Substrate nachträglich wieder beschichtet werden können. Das gemäß der Erfindung vorgelegte Verfahren soll bevorzugt zum gewerblichen bzw. wirtschaftlichen Entfernen von ta-C-Schichten von teuren Werkzeugen und Bauteilen dienen, die beispielsweise auch Oberflächen mit scharfen Kanten und/oder komplexen Geometrien aufweisen können. Außerdem sollte beim Verfahren das Entschichten von ta-C Schichten im Wesentlichen über plasmaunterstützte chemische Reaktionen erfolgen und jegliches Sputtern, d.h. das Abtragen von Material durch Ionenbeschuss, vermieden werden.

### Lösung der Aufgabe

Die Aufgabe wird durch ein Verfahren zum reaktiven Entschichten von Kohlenstoffschichten von den Substraten auf denen die besagten Kohlenstoffschichten abgeschieden wurden gelöst, insbesondere von ta-C Schichten von Bauteil- und Werkzeugoberflächen, bei dem das zu entschichtende Substrat auf einem Substrathalter in einer Vakuumkammer angeordnet wird, die Vakuumkammer mit mindestens einem den Abtransport von Kohlenstoff in Gasform unterstützendem Reaktivgas beschickt wird, und eine Niederspannungsplasmaentladung in der Vakuumkammer zur Anregung des Reaktivgases und somit zur Unterstützung der erforderlichen chemischen Reaktion bzw. Reaktionen zum Entschichten der beschichteten Substrat erzeugt wird, wobei:
1. die Niederspannungsplasmaentladung eine Gleichstrom-Niedervoltbogenentladung ist, die durch eine Entladespannung von maximal 120 V, vorzugsweise von maximal 80 V charakterisiert ist,
2. die zu entschichtende Substratoberflächen im Wesentlichen ausschließlich mit Elektronen beschossen werden, die wegen ihrer geringen Masse ein Sputtern ausschließen, oder mit Ionen einer Energie, die unterhalb der Sputterschwelle liegt, also kleiner als 20 eV ist,
3. um zumindest einen Teil der Kohlenstoffbeschichtung vom Substrat zu entfernen, und zumindest bei einem Schritt des reaktiven Entschichtens, vorzugsweise beim letzten Schritt des reaktiven Entschichtens, ein Gas eingesetzt wird, welches als Reaktivgas Stickstoff, vorzugsweise überwiegend Stickstoff, vorzugsweise im Wesentlichen Stickstoffgas umfasst.

### Beschreibung der Erfindung

Die Erfindung beruht auf der Anregung eines Reaktivgases, insbesondere von Stickstoff, in einer Gleichstrom-Niedervoltbogenentladung, die mit hohen Elektronenströmen bzw. Entladeströmen (typischerweise zwischen 20 A und 1000 A), aber bei niedriger Entladespannung (typischerweise zwischen 20 V und 80 V) betrieben wird.

Die Erfinder haben festgestellt, dass Gleichstrom-Niedervoltbogenentladungen trotz ihrer geringen Entladespannungen (bis maximal 120 V aber typischerweise bis etwa 80 V) nicht nur zur Durchführung wirtschaftlicher Reinigungsvorgänge geeignet sind, bei denen in der Regel nur Schichtdicken in der Größenordnung von etwa 10 nm abgetragen werden müssen (wie in EP0510340), sondern wirtschaftliche Entschichtungsverfahren von Kohlenstoffschichten bzw. Kohlenstoffbeschichtungen ermöglichen, die grundsätzlich und wesentlich eine deutlich größere Schichtdicke als 10 nm bzw. ≥ 0.1 µm aufweisen.

Außerdem haben die Erfinder festgestellt, dass überraschenderweise Stickstoff mit ta-C sehr reaktiv und infolgedessen zum reaktiven Entschichten von ta-C Schichten sehr gut geeignet ist. Ebenfalls konnten die Erfinder feststellen, dass durch die Reaktion von Stickstoff mit ta-C keine unerwünschten Nebenprodukte auf der Substratoberfläche zurückbleiben und keine unerwünschte Reaktion von Stickstoff mit dem Substrat stattfindet, sondern, falls überhaupt, ein Stickstoffanreichern der Substratoberfläche geschieht, was zur Stabilisierung der Substratoberfläche für eine Wiederbeschichtung vorteilhaft ist.

Das Entfernen von Kohlenstoffschichten bzw. von Kohlenstoffbeschichtungen, insbesondere von CVD- und oder PVD-Kohlenstoffschichten, die im Wesentlichen nur Kohlenstoffverbindungen aufweisen, ist erfindungsgemäß durch die Reaktion von Stickstoff und/oder Sauerstoff mit Kohlenstoff möglich, indem das Stickstoffgas und/oder Sauerstoffgas mittels einer Gleichstrom-Niedervoltbogenentladung, angeregt wird, wobei die Gleichstrom-Nierdervoltbogenentladung mit hohen Elektronenströmen bzw. Entladeströmen (typischerweise zwischen 20 A und 1000 A), aber bei niedrigen Entladespannungen (typischerweise zwischen 20 V und 80 V betrieben wird.
Das reaktive Entschichten gemäß der vorliegenden Erfindung kann in einem Schritt oder in mehreren Schritten durchgeführt werden.
Nachfolgend werden bevorzugte Ausführungen der vorliegenden Erfindung beschrieben, anhand derer jegliches Sputtern (Abtragen von Material durch Ionenbeschuss), das teure Substrate mit scharfen Kanten und/oder komplexen Geometrien beschädigen könnte, vermieden wird:

### Verfahrensvariante A:

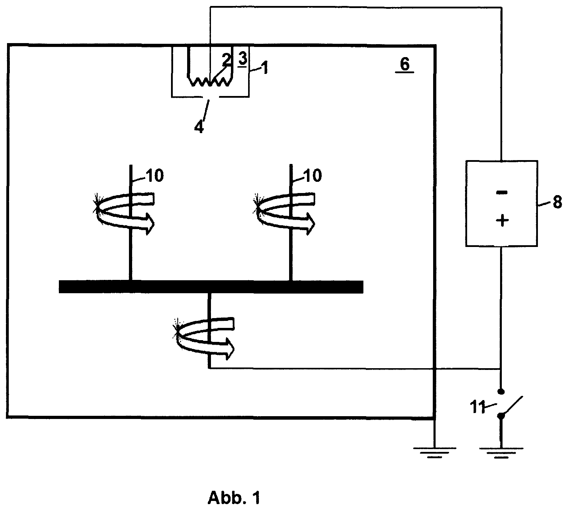

Nach der Verfahrensvariante A werden vorzugsweise die Substrate in der Gleichstrom-Niedervoltbogenentladung als Anode geschaltet. Diese Verfahrensvariante A ist in Abbildung 1 schematisch dargestellt. Die Gleichstrom-Niedervoltbogenentladung (nicht dargestellt) wird durch eine Plasmaquelle 1 gespeist, die aus einem geheiztem Filament 2 besteht, das als Kathode in der Gleichstrom-Niedervoltbogenentladung geschaltet ist und sich in einer Filamentkammer 3 befindet, welche über eine kleinere Öffnung 4 (typisch zwischen 2 mm und 10 mm Durchmesser) mit der Vakuumkammer 6 verbunden ist, wobei die Filamentkammer von der Vakuumkammer elektrisch isoliert ist. In die Filamentkammer 3 wird ein Arbeitsgas eingelassen. Hier sollen, ohne Einschränkung auf die Art des Arbeitsgases, die Experimente für Argon beschrieben werden. Aber es ließe sich beispielsweise auch Stickstoff oder Neon verwenden. Gepumpt wird das Arbeitsgas über das Pumpsystem der Vakuumkammer (nicht gezeichnet), was dazu führt, dass sich wegen der kleinen Öffnung 4, in der Filamentkammer 3 ein höherer Gasdruck einstellt als in der Vakuumkammer 6. Durch die kleine Öffnung 4 treten die hohen Elektronenströme in die Vakuumkammer 6, in der sich die in der Substrathalterung 10 zu entschichtenden Substrate (nicht gezeichnet) befinden. Das Reaktivgas wird über ein Ventil oder einen Flussregler (beides nicht gezeichnet) direkt in die Vakuumkammer 6 eingelassen.

Da die Substrate im Verfahren A anodisch geschaltet sind, werden die Substratoberflächen mit Elektronen beschossen, die wegen ihrer geringen Masse ein Sputtern ausschließen. Dafür regen sie im Entladungsbereich und unmittelbar an der Substratoberfläche die Reaktivgase (hier im Wesentlichen Stickstoffgas) an. Wahrscheinlich erfolgt eine Zerlegung/Anregung des molekularen Stickstoffs in atomaren Stickstoff, der bekanntermaßen bei tiefen Temperaturen viel reaktiver ist als molekularer Stickstoff. Dadurch kommt es zu Reaktionen mit der ta-C Schicht und zur Bildung von flüchtigen Verbindungen zwischen Kohlenstoff und Stickstoff, die entweder genügend stabil sind, damit sie über das Vakuumsystem abgepumpt werden können, oder die sich an anderen (kälteren) Stellen im Innern der Vakuumanlage ablagern.
Die verwendeten Entladeströme des Verfahrens A können auf die Größe der zu entschichteten Substratoberflächen einfach abgestimmt werden, weil mittels des Gleichstromgenerators 8 der Strom und damit die Stromdichte am Substrat eingestellt werden kann. Zusätzlich besteht die Möglichkeit, dass vor allem bei temperatursensitiven Substraten, ein Teil des Entladestromes auf die Vakuumkammer abgezogen wird. Das kann dadurch geschehen, dass die Gleichstromquelle mittels eines Schalters 11 anodisch auf Masse (wie die Vakuumkammer) gelegt wird, indem z.B. der Schalter 11 in der in Abbildung 1 skizzierte Anordnung geschlossen wird.

Dem Stickstoffreaktivgas können auch noch weitere Gase zugegeben werden, um einmal die Reaktionen vor allem bei sehr dicken Schichten zu beschleunigen oder gleichzeitig mit der Entfernung des ta-C auch noch andere unerwünschte Schicht- oder Interfacebestandteile durch eine chemische Reaktion zu entfernen. Eine Zugabe von Wasserstoff reduziert sowohl Sauerstoffbestandteile in der Schicht, aber auch unerwünschte Reste von Sauerstoff auf der entschichteten Substratoberfläche. Falls Sauerstoff der Entladung zugegeben wird, kann die Entfernung von ta-C beschleunigt werden. Allerdings ist es sinnvoll, den Sauerstoff früh genug abzuschalten, ehe es zu einer vollständigen Entfernung der ta-C Schicht kommt und der damit verbundenen Gefahr die entschichtete Substratoberfläche bzw. die durch das Entschichten freiliegenden Substratoberflächen zu oxidieren.

### Verfahrensvariante B:

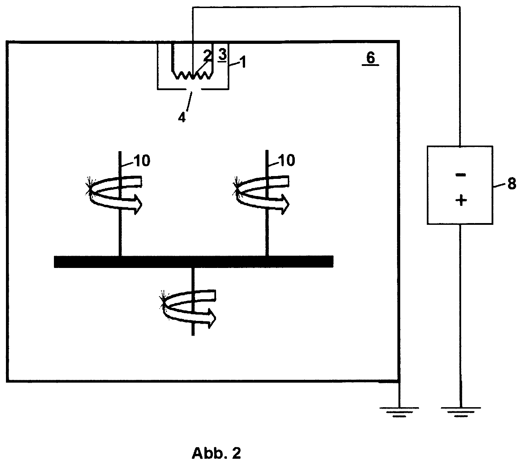

In einer weiteren Verfahrensvariante B, wie in Abbildung 2 schematisch dargestellt, wird die Gleichstrom-Niedervoltbogenentladung gegen Masse als Anode betrieben und die Substrate lediglich in das Plasma eingetaucht, also während des Entschichtungsprozesses auf Schwebepotential gehalten. Das hat zur Folge, dass sich die Substrate leicht negativ aufladen. Diese Substratspannung liegt aber mit weniger als 20 V unter der Sputterschwellenspannung. Also auch in diesem Prozess wird das Sputtern verhindert.

### Verfahrensvariante C:

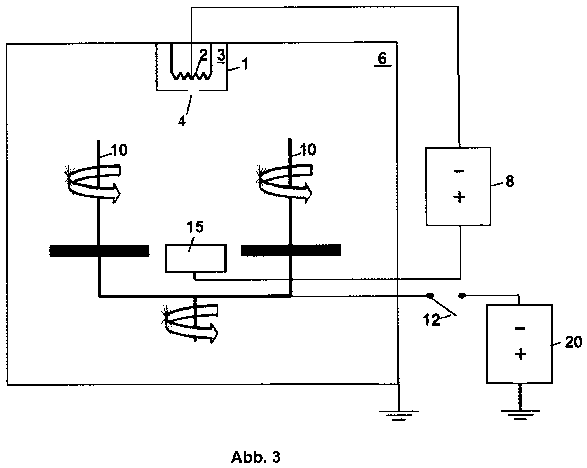

Eine abschliessende Verfahrensvariante C wird in Abbildung 3 schematisch dargestellt. In dieser Anordnung wird die Gleichstrom-Niedervoltbogenentladung gegen eine zusätzliche Elektrode 15 in der Kammer, die als Anode geschaltet ist, betrieben. Der Platz dieser Hilfsanode 15 ist bevorzugt innerhalb der Substratanordnung, also beispielsweise im Zentrum der Vakuumkammer. Die Substrate liegen wieder auf Schwebepotential und es tritt wieder, wie bei der Variante B, kein Sputtern auf, weil die negative Substratspannung zu klein für Sputterprozesse ist. Mit einer zusätzlichen Versorgung 20 können aber die Substrate mit einer negativen Spannung beaufschlagt werden, falls es notwendig sein sollte, die Substrate nach dem Entschichten noch zusätzlich zu sputterätzen.

Vorteile bei der Verwendung einer Gleichstrom-Niedervoltbogenentladung nach einer der in Abbildungen 1 bis 3 skizzierten Anordnungen bzw. Verfahrensvarianten A bis C im Vergleich zu einer Sputterplasmaentladung (wie die z.B. in EP2180499 beschriebenen ist) sind zum Beispiel folgende:
1. Der Entladestrom kann so hoch eingestellt werden, dass für beliebige Gasflüsse ausreichend Gas dissoziiert oder angeregt wird, um die chemische Reaktion zum Entschichten von ta-C auf die Substratoberflächen so effizient wie möglich durchzuführen. Zudem lässt sich über den Entladestrom auch die Strom- und Leistungsdichte am Substrat einstellen.
2. Die Gleichstrom-Niedervoltbogenentladung kann in der Vakuumkammer beliebig platziert werden, so dass die gleiche Vakuumkammer, die zum Entschichten verwendet wurde auch zum Beschichten verwendet werden kann. Auch die gleiche Substrathalterung kann sowohl zum Entschichten wie zum Beschichten verwendet werden.
3. Mit der Auswahl einer geeigneten Anode (Anodenaufbau, Anodenmaterial, etc.) kann auch ein Prozess mit Sauerstoffplasma zum Entschichten verwendet werden, der während langer Zeit stabil laufen kann.

Im Folgenden werden nun einige Beispiele für Entschichtungsprozesse angeführt. Es wird aber lediglich (falls nicht ausdrücklich anders genannt) auf die Verfahrensvariante A mit dem Schalter 11 geöffnet eingegangen, obwohl die Gasmischungen ebenso gut für die anderen Varianten gelten, es höchstens zu Anpassungen in der Entschichtungsdauer kommen kann. Dem Fachmann ist es auch klar, dass die Erhöhung des Entladestromes und die damit zusammenhängende Erhöhung der Elektronendichte Einfluss auf die Entschichtungsdauer hat, zumindest solange genügend Reaktivgas zum Aktivieren vorhanden ist. Es gilt in einem Druckbereich bis etwa 5 Pa: Je höher der Bogenstrom und je grösser der Gasfluss, umso grösser die Entschichtungsrate. Ganz allgemein gilt auch, dass bei höheren Substrattemperaturen die Entschichtungsrate erhöht wird. Darauf wird bei den Beispielen nicht detailliert eingegangen, aber es ist dem Fachmann bewusst, dass ein Hartmetallsubstrat thermisch stärker belastet werden kann als eines aus HSS Stahl oder Aluminium, womit gezielt die Entschichtungsraten beeinflusst werden können.

In Tabelle 1 sind einige Kombinationen für mögliche Gasflüsse aufgeführt, die teilweise in weiter unten folgenden Beispielen näher erläutert werden. Die in Tab. 1 beispielweise angegebenen Gasflüsse sowie die nachfolgend gemäß der vorliegenden Erfindung angegebenen Beispiele zum Entschichten von Kohlenstoffschichten können beliebig wie erforderlich (z.B. unter Berücksichtigung der Größe der gesamten zu entschichtenden Oberfläche, Schichtdicke, Substratmaterial und Geometrie, Art der Kohlenstoffverbindungen) angepasst werden. Es ist weiterhin zu berücksichtigen, dass sich die Erfindung nicht auf diese Beispiele beschränkt, sondern weitere, hier nicht aufgeführte Ausgestaltungen, gestattet.

**Tabelle 1: Prozessgasvarianten**

| Prozess | Ar [sccm] | N2 [sccm] | O2 [sccm] | H2 [sccm] | Totaldruck [10⁻³ mbar] |
|---|---|---|---|---|---|
| 1 | 60 | | | | 2.1 |
| 2 | 100 | | | | 3.2 |
| 3 | 60 | 200 | | | 6.8 |
| 4 | 60 | 400 | | | 12 |
| 5 | 60 | 800 | | | 24 |
| 6 | 60 | 100 | | 100 | 4.6 |
| 7 | 60 | 100 | | 200 | 6 |
| 8 | 60 | 100 | | 400 | 14 |
| 9 | 60 | 200 | | 400 | 17 |
| 10 | 60 | 100 | 100 | | 6.8 |
| 11 | 60 | | 100 | 200 | 6 |
| 12 | 60 | | 100 | 400 | 14 |
| 13 | 60 | 300 | 100 | | 12 |
| 14 | 60 | 100 | 100 | 400 | 17 |
| 15 | 60 | | 200 | 400 | 17 |

Die Prozesse 1 und 2 in Tabelle 1 zeigen exemplarisch Druckwerte in der Entschichtungskammer, wenn die Gleichstrom-Nierdervoltbogenentladung bei einem Entladestrom von 150 A und einem Argonfluss von 60 sccm (Prozess 1) oder 100 sccm (Prozess 2) vor dem Einlass eines Reaktivgases in die Entschichtungskammer betrieben wird.

### Beispiel 1 (erfindungsgemässes Ausführungsbeispiel):

Es wurde ein Entladestrom von 150 A eingestellt mit einem Argonfluss von 60 sccm. Anschliessend wurden 200 sccm N₂ als Reaktivgas in die Vakuumkammer eingelassen, was zu einem Totaldruck von 0.68 Pa in der Vakuumkammer führte (entsprechend dem Prozess 3 in Tabelle 1). Nach 4 h ist eine ta-C Schicht mit einerSchichtdicke von 2 µm vollständig von einem Hartmetallformwerkzeug entfernt worden. Man konnte mit diesem Beispiel bestätigen, dass ta-C Schichten trotz ihres sehr hohen Anteils von tetraedrischen diamantartigen Bindungen gemäss der vorliegenden Erfindung sehr schnell mit einer Entschichtungsrate von etwa 0.5 µm/h von der Werkzeugoberfläche entfernt wird. Die Entschichtung erfolgte bei 500°C Substrattemperatur.

### Beispiel 2 (erfindungsgemässes Ausführungsbeispiel):

Für die exakt gleichen Prozessparameter, aber für eine unterschiedliche Substrattemperatur von 280°C wurde von einem Stahlstempel zur Aluminium-Umformung eine 1 µm dicke ta-C Schicht in 5 h entfernt, was einer Entschichtungsrate von 0.2 µm/h entspricht. Das demonstriert den Einfluss der Substrattemperatur auf die Entschichtungsrate.

### Beispiel 3 (erfindungsgemässes Ausführungsbeispiel):

Für das Entschichten einer ta-C Schicht mit einer Schichtdicke von 5 µm wurde das erfindungsgemässe Entschichten in zwei Schritten durchgeführt und als Reaktivgas wurde für jeden Schritt ein stickstoffenthaltiges Mischgas verwendet. Die Gleichstrom-Niedervoltbogenentladung wurde bei einem Entladestrom von 150 A und einem Argonfluss von 60 sccm betrieben. Anschliessend wurde für den ersten Schritt ein Mischgas aus 300 sccm N₂ und 100 sccm O₂ während 60 min in die Entschichtungskammer eingelassen (entsprechend dem Prozess 13 in Tabelle 1). Schliesslich wurde (bevor die ta-C Schicht vollständig entfernt war) für den zweiten Schritt ein Mischgas aus 100 sccm N₂ und 400 sccm H₂ (entsprechend dem Prozess 8 in Tabelle 1) während 30 min in die Vakuumkammer eingelassen, um zu vermeiden, dass die durch die Entschichtung freiliegende Substratoberfläche oxidiert wird. Nach den Schritten 1 und 2 bzw. nach 1,5 h waren die Substrate vollständig entschichtet und es gab keine unerwünschten Rückstände mehr auf der Substratoberfläche.

### Beispiel 4:

In einem weiteren Prozess bei gleichen Entladestrom und Arbeitsgasfluss wie im Beispiel 3 (auch nach der Verfahrensvariante A mit dem Schalter 11 geöffnet), aber mit lediglich Sauerstoff als Reaktivgas, konnten mit ta-C beschichtete Hartmetallfräser entschichtet werden. Neben dem Argon (Arbeitsgas) wurde das für den Entschichtungsvorgang verantwortliche Sauerstoffgas direkt in die Vakuumkammer mit einem konstanten Sauerstofffluss von 400 sccm eingelassen. Das eingelassene Sauerstoffgas wurde durch die Plasmaentladung in einer Weise angeregt, dass der Sauerstoff mit dem Kohlenstoff der ta-C Schichten reagierten und dessen gasförmige Abtragungsprodukte (mehrheitlich CO₂) über das Vakuumpumpsystem weggeführt wurden. Unter diesen Bedingungen konnten ta-C Schichten mit Schichtdicken von 2 µm von Fräsern aus Hartmetall mit Ø 12 mm problemlos und innerhalb von 1 h komplett entfernt werden.

Jedoch führte die Behandlung im Sauerstoffplasma zu geringer Oxidation der Substratoberfläche. Diese dünnen Oxidschichten mussten in einem zweiten Schritt mit Hilfe eines Sputterätzverfahrens entfernt werden. In dem zweiten Schritt wurde die Gleichstrom-Niedervoltbogenentladung zwischen Filament und Hilfsanode weiter bei einem konstanten Entladestrom von 150 A betrieben und anschließend Wasserstoff (bei ausgeschaltetem Sauerstofffluss) in die Vakuumkammer eingelassen, mit einem konstanten Gasfluss von 250 sccm. Zusätzlich wurde eine negative Bias-Spannung von 200 V (-DC) am Substrathalter angelegt (ähnliche Prozessanordnung wie nach der Verfahrensvariante C in Abbildung 3 mit dem Schalter 12 zu). Die Oxidschichten wurden so durch Wasserstoffätzen nach 30 min komplett entfernt. Nachteilig bei diesem nicht erfindungsgemässen Verfahren ist aber der Ionenbeschuss des Substrates, der im zweiten Schritt stattfindet, und das damit verbundene Sputtern des Substrates.

### Beispiel 5 (erfindungsgemässes Ausführungsbeispiel):

Bei der gleichen Anordnung wie im Beispiel 4 (im Schritt 1), aber mit Stickstoff als Reaktivgas wurden problemlos ta-C Schichten mit Schichtdicken von 2 µm von Fräsern aus Hartmetall mit Ø 12 mm innerhalb von etwa 4 Stunden komplett entfernt, was einer Entschichtungsrate von etwa 0.5 µm/h entspricht.

Trotz der längeren Entschichtungszeiten beim Entschichten von ta-C Schichten unter Verwendung von Stickstoff statt Sauerstoff als Reaktivgas, kann die Verwendung von Stickstoff als vorteilhaft angesehen werden, weil keine dünnen Oxidschichten auf der Substratoberfläche zurückbleiben. So ist ein nachträgliches Wasserstoffätzen nicht mehr erforderlich, was bei der Entschichtung von teuren Substraten mit scharfen Kanten und/oder komplizierten Geometrien vorteilhafterweise vermieden werden soll.

### Beispiel 6 (erfindungsgemässes Ausführungsbeispiel):

Das Entschichten kann auch erfindungsgemäss, insbesondere für grosse Schichtdicken in verschiedenen Schritten durchgeführt werden, indem beim ersten Schritt des Entschichtens im Wesentlichen Sauerstoff als Reaktivgas verwendet wird aber der Sauerstofffluss früh genug, d.h. bevor der ta-C Schicht vollständig entfernt ist, abgeschaltet wird und anschliessend für den zweiten Schritt ein Mischgas aus Stickstoffgas und Wasserstoffgas als Reaktivgas bis zum vollständigen Entfernen der Kohlenstoffschicht verwendet wird. Hierdurch wird eine Oxidation der durch die Entschichtung freiliegenden Substratoberflächen vermieden.

### Beispiel 7 (erfindungsgemässes Ausführungsbeispiel):

Erfindungsgemäss kann ebenso das Entschichten von dickeren Kohlenstoffschichten so ausgeführt werden, dass in ähnlicher Weise wie im Beispiel 6 in einem ersten Schritt des Entschichtens im Wesentlichen Sauerstoffgas als Reaktivgas zum Entschichten eines ersten Teils der gesamten Kohlenstoffschicht verwendet wird (wobei der Sauerstofffluss früh genug abgeschaltet wird bzw. bevor der ta-C Schicht an irgendwelcher Substratstelle vollständig entfernt wird und die durch die Reaktion mit Sauerstoff entschichtete Oberfläche zu oxidieren anfängt), in einem zweiten Schritt des Entschichtens eine Gasmischung aus zum Beispiel Wasserstoffgas und Stickstoffgas zum Entschichten eines zweiten Teils der gesamten Kohlenstoffschicht verwendet wird und abschliessend in einem dritten Schritt im Wesentlichen Stickstoffgas zum Entschichten des letzten Teils der gesamten Kohlenstoffschicht, bzw. bis zum vollständigen Entschichten der Kohlenstoffschicht verwendet wird.

Erfindungsgemäss sind auch alle Entschichtungsverfahren, die aus der Kombinationen der angegeben Ausführungsbeispiele resultieren.

Es können auch verschiedenen Substraten mit unterschiedlichen Schichtdicken in einem gleichen Batch mit Hilfe des erfindungsgemässen Verfahrens entschichtet werden, wobei wenn beim ersten Schritt des Entschichtens Sauerstoffgas oder ein sauerstoffenthaltendes Gas als Reaktivgas verwendet wird, berechnet werden muss, wie lange dieser erste Schritt dauern soll, so dass die Oxidierung von entschichteten Substratoberflächen vermieden wird.

Mit Hilfe von dem Entschichtungsverfahren gemäss der vorliegenden Erfindung können auch Kohlenstoffschichten entfernt werden, die ausser Kohlenstoff auch andere nichtmetallischen Elementen enthalten, wie zum Beispiel Wasserstoff (H), Bor (B), Silizium (Si) und Germanium (Ge) enthalten.

Anschliessend wird die vorliegende Erfindung kurzgefasst:

Die vorliegende Erfindung betrifft ein Verfahren zum reaktiven Entschichten von Kohlenstoffschichten von einem Substrat, insbesondere zum reaktiven Entschichten von ta-C Schichten von Bauteil- und Werkzeugoberflächen, bei dem das zu entschichtende Substrat auf einen Substrathalter in einer Vakuumkammer angeordnet wird, die Vakuumkammer mit mindestens einem den Abtransport von Kohlenstoff in Gasform unterstützenden Reaktivgas beschickt wird, und eine Plasmaentladung in der Vakuumkammer zur Unterstützung der erforderlichen chemischen Reaktion bzw. Reaktionen zum Entschichten der beschichteten Substrat gezündet wird, und das reaktive Entschichten in einem Schritt oder mehreren Schritten durchgeführt wird, wobei die Plasmaentladung als Gleichstrom-Niedervoltbogenentladung erzeugt wird, die Entladeströmen zwischen 20 A und 1000 A, vorzugsweise zwischen 50 A und 300 A und einer Entladespannung von maximal 120 V, vorzugsweise zwischen 20 V und 80 V aufweist.

Das gemäß der vorliegenden Erfindung oben beschriebene Entschichtungsverfahren wird vorzugsweise derart ausgeführt, dass:
- das Substrat als Anode für die Gleichstrom-Niedervoltbogenentladung eingeschalten wird und dadurch im Wesentlichen die Substratoberfläche ausschließlich mit Elektronen beschossen wird, die wegen ihrer geringen Masse ein Sputtern ausschließen, oder
- das Substrat isolierend in die Gleichstrom-Niedervoltbogenentladung eingebracht wird, dadurch die auf das Substrat auftreffenden Ionen im wesentlichen Energien unter 20 eV haben bzw. unter der Sputterschwelle liegen, oder
- für die Gleichstrom-Niedervoltbogenentladung eine von dem Substrathalter und der Kammerwand sich unterscheidende Elektrode als Anode verwendet wird und die Substrate auf floatendem Potiential gehalten werden.

Das Entschichtungsverfahren wird gemäß der vorliegenden Erfindung derart ausgeführt, dass um zumindest einen Teil der Kohlenstoffbeschichtung vom Substrat zu entfernen während zumindest eines Schrittes des reaktiven Entschichtens, vorzugsweise während des letzten Schrittes des reaktiven Entschichtens ein stickstoffgasumfassendes Gas als Reaktivgas eingesetzt wird, vorzugsweise das eingesetzte stickstoffgasumfassende Reaktivgas überwiegend Stickstoffgas umfasst, noch vorzugsweise das eingesetzte stickstoffgasumfassende Reaktivgas im Wesentlichen Stickstoffgas umfasst.
Weiters wird das Entschichtungsverfahren gemäß der vorliegenden Erfindung derart ausgeführt, dass um zumindest einen Teil der Kohlenstoffbeschichtung vom Substrat zu entfernen während zumindest eines Schrittes des reaktiven Entschichtens, nicht jedoch während des letzten Schrittes des reaktiven Entschichtens, vorzugsweise während des ersten Schrittes des reaktiven Entschichtens ein sauerstoffgasumfassendes Gas als Reaktivgas eingesetzt wird, vorzugsweise das eingesetzte sauerstoffgasumfassende Reaktivgas überwiegend Sauerstoffgas umfasst, noch vorzugsweise das eingesetzte sauerstoffgasumfassende Reaktivgas im Wesentlichen Sauerstoffgas umfasst. Vorzugsweise wird der Fluss des sauerstoffgasumfassenden Reaktivgases abgeschaltet bevor der Kohlenstoffschicht an irgendwelcher Substratstelle durch die Reaktion mit Sauerstoff vollständig entfernt wird und die so entschichtete Substratoberfläche auch durch die Reaktion mit Sauerstoff zu oxidieren anfängt. Vorzugsweise wird Wasserstoffgas in die Entschichtungskammer eingeleitet nachdem der Fluss des sauerstoffgasumfassenden Reaktivgases abgeschaltet wird, dadurch sowohl Sauerstoffbestandteile in der Schicht als auch unerwünschte Reste von Sauerstoff auf der Substratoberfläche reduziert werden.
Die vorliegende Erfindung betrifft ebenfalls ein Verfahren zum reaktiven Entschichten von Kohlenstoffschichten von einem Substrat, insbesondere zum reaktiven Entschichten von ta-C Schichten von Bauteil- und Werkzeugoberflächen, bei dem das zu entschichtende Substrat auf einen Substrathalter in einer Vakuumkammer angeordnet wird, die Vakuumkammer mit mindestens einem den Abtransport von Kohlenstoff in Gasform unterstützenden Reaktivgas beschickt wird und eine Plasmaentladung in der Vakuumkammer zur Unterstützung der erforderlichen chemischen Reaktion bzw. Reaktionen zum Entschichten der beschichteten Substrat gezündet wird, und das reaktive Entschichten in einem Schritt oder mehreren Schritten durchgeführt wird, wobei um zumindest einen Teil der Kohlenstoffschicht vom Substrat zu entfernen, zumindest im letzten Schritt des reaktiven Entschichtens ein Gas eingesetzt wird, welches als Reaktivgas Stickstoffgas umfasst. Vorzugsweise umfasst das stickstoffgasumfassende Reaktivgas überwiegend Stickstoffgas und besonders bevorzugt umfasst das stickstoffgasumfassende Reaktivgas im Wesentlichen Stickstoffgas.

Das Entschichtungsverfahren gemäß der vorliegenden Erfindung kann auch zum Entschichten von Substraten verwendet werden, die mit Kohlenstoffschichten beschichtet sind, wobei die Kohlenstoffschichten neben Kohlenstoff auch andere nichtmetallischen Elemente, insbesondere Wasserstoff (H), Bor (B), Silizium (Si) und/oder Germanium (Ge), enthalten.

### Legende der Abbildungen

Abbildung 1: Verfahrensvariante A
Abbildung 2: Verfahrensvariante B
Abbildung 3: Verfahrensvariante C

## Patentansprüche

1. Verfahren zum reaktiven Entschichten von Kohlenstoffschichten von einem Substrat, insbesondere zum reaktiven Entschichten von ta-C Schichten von Bauteil- und Werkzeugoberflächen, bei dem das zu entschichtende Substrat auf einen Substrathalter in einer Vakuumkammer angeordnet wird, die Vakuumkammer mit mindestens einem den Abtransport von Kohlenstoff in Gasform unterstützenden Reaktivgas beschickt wird, und eine Plasmaentladung in der Vakuumkammer zur Unterstützung der erforderlichen chemischen Reaktion bzw. Reaktionen zum Entschichten der beschichteten Substrat gezündet wird, und das reaktive Entschichten in einem Schritt oder mehreren Schritten durchgeführt wird, **dadurch gekennzeichnet, dass** die Plasmaentladung als Gleichstrom-Niedervoltbogenentladung erzeugt wird, die Entladeströmen zwischen 20 A und 1000 A, vorzugsweise zwischen 50 A und 300 A und einer Entladespannung von maximal 120 V, vorzugsweise zwischen 20 V und 80 V aufweist, und um zumindest einen Teil der Kohlenstoffbeschichtung vom Substrat zu entfernen, während zumindest eines Schrittes des reaktiven Entschichtens, vorzugsweise während des letzten Schrittes des reaktiven Entschichtens, ein stickstoffgasumfassendes Gas als Reaktivgas eingesetzt wird, wobei vorzugsweise das eingesetzte stickstoffgasumfassende Reaktivgas überwiegend Stickstoffgas umfasst und besonders bevorzugt das eingesetzte stickstoffgasumfassende Reaktivgas im Wesentlichen Stickstoffgas umfasst.

2. Verfahren nach Anspruch 1, **dadurch gekennzeichnet, dass** das Substrat als Anode für die Gleichstrom-Niedervoltbogenentladung eingeschalten wird und dadurch im Wesentlichen die Substratoberfläche ausschließlich mit Elektronen beschossen wird, die wegen ihrer geringen Masse ein Sputtern ausschließen.

3. Verfahren nach Anspruch 1, **dadurch gekennzeichnet, dass** das Substrat isolierend in die Gleichstrom-Niedervoltbogenentladung eingebracht wird, dadurch die auf das Substrat auftreffenden Ionen im wesentlichen Energien unter 20 eV haben und damit unter der Sputterschwelle liegen.

4. Verfahren nach Anspruch 1, **dadurch gekennzeichnet, dass** für die Gleichstrom-Niedervoltbogenentladung eine von dem Substrathalter und der Kammerwand sich unterscheidende Elektrode als Anode verwendet wird und die Substrate auf floatendem Potential gehalten werden.

5. Verfahren nach einem der vorhergehenden Ansprüche, **dadurch gekennzeichnet, dass,** um zumindest einen Teil der Kohlenstoffbeschichtung vom Substrat zu entfernen während zumindest eines Schrittes des reaktiven Entschichtens, nicht jedoch während des letzten Schrittes des reaktiven Entschichtens, vorzugsweise während des ersten Schrittes des reaktiven Entschichtens ein sauerstoffgasumfassendes Gas als Reaktivgas eingesetzt wird, wobei vorzugsweise das eingesetzte sauerstoffgasumfassende Reaktivgas überwiegend Sauerstoffgas umfasst und besonders bevorzugt das eingesetzte sauerstoffgasumfassende Reaktivgas im Wesentlichen Sauerstoffgas umfasst.

6. Verfahren nach Anspruch 5, **dadurch gekennzeichnet, dass** der Fluss des sauerstoffgasumfassenden Reaktivgases abgeschaltet wird bevor der Kohlenstoffschicht an irgendeiner Substratstelle durch die Reaktion mit Sauerstoff vollständig entfernt wird und somit verhindert wird, dass eine entschichtete Substratoberfläche auch durch die Reaktion mit dem Sauerstoff zu oxidieren anfängt.

7. Verfahren nach Anspruch 6, **dadurch gekennzeichnet, dass** nachdem der Fluss des sauerstoffgasumfassenden Reaktivgases abgeschaltet wird, Wasserstoffgas in die Entschichtungskammer eingeleitet wird und dadurch sowohl Sauerstoffbestandteile in der Schicht als auch unerwünschte Reste von Sauerstoff auf der Substratoberfläche reduziert werden.

8. Verwendung eines Verfahrens nach einem der vorhergehenden Ansprüche zum Entschichten von Substraten, die mit Kohlenstoffschichten beschichtet sind, wobei die Kohlenstoffschichten neben Kohlenstoff auch andere nichtmetallischen Elemente, insbesondere Wasserstoff (H), Bor (B), Silizium (Si) und/oder Germanium (Ge), enthalten.

## Claims

1. Process for the reactive decoating of carbon layers from a substrate, particularly for the reactive decoating of ta-C coatings from the surface of parts and tools, in which the substrate to be decoated is placed on a substrate holder in a vacuum chamber, the vacuum chamber is charged with at least one reactive gas supporting the removal of carbon in gaseous form, and a plasma discharge is initiated in the vacuum chamber to support the necessary chemical reaction or reactions to decoat the coated substrate, and the reactive decoating is carried out in one step or several steps, **characterized in that** the plasma discharge is produced as a direct current low voltage arc discharge, with discharge currents between 20 A and 1000 A, preferably between 50 A and 300 A, with discharge voltage of at most 120 V, preferably between 20 V and 80 V, and to remove at least a portion of the carbon coating from the substrate during at least one step of the reactive decoating, preferably during the last step of the reactive de-coating, a gas containing nitrogen gas is used as the reactive gas, wherein preferably the used nitrogen-containing reactive gas comprises predominantly nitrogen gas, and especially preferably the used nitrogen-containing reactive gas comprises essentially nitrogen gas.

2. Process according to claim 1, **characterized in that** the substrate is connected as the anode for the direct current low voltage arc discharge, and thereby the substrate surface is bombarded essentially exclusively with electrons, which due to their low mass exclude any sputtering.

3. Process according to claim 1, **characterized in that** the substrate is brought into the direct current low voltage arc discharge in an insulated manner, so that the ions hitting the substrate have energies essentially under 20 eV, and therefore are below the sputtering threshold.

4. Process according to claim 1, **characterized in that** an electrode differing from the substrate holder and the chamber wall is used as the anode for the direct current low voltage arc discharge, and the substrates are maintained at floating potential.

5. Process according to one of the preceding claims, **characterized in that** to remove at least a portion of the carbon coating from the substrate during at least one step of the reactive de-coating, but not during the last step of the reactive de-coating, preferably during the first step of the reactive de-coating, a gas containing oxygen gas is used as the reactive gas, wherein preferably the used oxygen-containing reactive gas comprises predominantly oxygen gas, and especially preferably the used oxygen-containing reactive gas comprises essentially oxygen gas.

6. Process according to claim 5, **characterized in that** the flow of oxygen-containing reactive gas is terminated before the carbon layer is completely removed at any part of the substrate by the reaction with oxygen, so that it is prevented that any de-coated substrate surface begins to be oxidized by the reaction with the oxygen.

7. Process according to claim 6, **characterized in that** after the flow of the oxygen-containing reactive gas is terminated, hydrogen gas is introduced into the decoating chamber, so that oxygen components in the coating and undesirable residue of oxygen on the substrate surface are reduced.

8. Application of a process according to one of the preceding claims for the decoating of substrates coated with carbon layers, wherein the carbon layers contain in addition to carbon other non-metallic elements, particularly hydrogen (H), boron (B), silicon (Si) and/or germanium (Ge).

## Revendications

1. Procédé d'enlèvement réactif de couches de carbone d'un substrat, en particulier d'enlèvement réactif de couches ta-C de surfaces de composants et d'outils où le substrat dont la couche est à enlever est mis en place sur un porte-substrat dans une chambre vide, la chambre vide étant chargée d'au moins un gaz réactif soutenant l'enlèvement de carbone en forme gazeuse, et une décharge de plasma est amorcée dans la chambre vide pour soutenir la réaction ou les réactions chimiques nécessaires pour enlever la couche du substrat revêtu, et l'enlèvement réactif de couches s'effectue en une étape ou en plusieurs étapes, **caractérisé par le fait que** la décharge de plasma est engendrée comme une décharge en arc à basse tension et courant continu, ayant des courants de décharge entre 20 A et 1000 A, de préférence entre 50 A et 300 A et une tension de décharge de 120 V au maximum, de préférence entre 20 V et 80 V, et pour enlever du moins une partie de la couche de carbone du substrat pendant du moins une étape de l'enlèvement réactif de couches, de préférence pendant la dernière étape de l'enlèvement réactif de couches,un gaz comprenant de l'azote gazeux est utilisé comme gaz réactif, de préférence le gaz réactif utilisé qui contient de l'azote gazeux comprenant en grande partie de l'azote gazeux et de façon particulièrement préférée le gaz réactif utilisé qui contient de l'azote gazeux comprenant essentiellement de l'azote gazeux.

2. Procédé selon la revendication 1, **caractérisé par le fait que** le substrat est branché comme anode pour la décharge en arc à basse tension et courant continu et de ce fait la surface de substrat est essentiellement bombardée exclusivement d'électrons qui en raison de leur masse excludent une pulvérisation.

3. Procédé selon la revendication 1, **caractérisé par le fait que** le substrat est mis dans la décharge en arc à basse tension et courant continu de manière isolante, de sorte que les ions frappant le substrat ont des énergies qui sont essentiellement inférieures à 20 eV et, par conséquent, inférieures au seuil de pulvérisation.

4. Procédé selon la revendication 1, **caracterisé par le fait qu'**une électrode différant du porte-substrat et de la chambre vide est utilisée comme anode pour la décharge en arc à basse tension et courant continu et les substrats sont maintenus à potentiel flottant.

5. Procédé selon une des revendications précédentes, **caracterisé par le fait que,** pour enlever du moins une partie de la couche de carbone du substrat pendant du moins une étape de l'enlèvement réactif de couches, mais pas pendant la dernière étape de l'enlèvement réactif de couches, de préférence pendant la première étape de l'enlèvement réactif de couches, un gaz comprenant de l'oxygène gazeux est utilisé comme gaz réactif, de préférence le gaz réactif utilisé qui contient de l'oxygène gazeux comprenant en grande partie de l'oxygène gazeux et de façon particulièrement préférée le gaz réactif utilisé qui contient de l'oxygène gazeux comprenant essentiellement de l'oxygène gazeux.

6. Procédé selon la revendication 5, **caractérisé par le fait que** le flux du gaz réactif comprenant de l'oxygène gazeux est terminé avant que la couche de carbone soit complètement enlevée à quelconque endroit du substrat par la réaction avec l'oxygène de sorte qu'on évite qu'une surface de substrat dont la couche avait été enlevée commence à oxyder par la réaction avec l'oxygène.

7. Procédé selon la revendication 6, **caracterisé par le fait que,** après que le flux du gaz réactif comprenant de l'oxygène gazeux est terminé, l'hydrogène gazeux est introduit dans la chambre d'enlèvement de couche de sorte que des components d'oxygène dans la couche ainsi que des restes indésirables d'oxygène sur la surface de substrat sont réduits.

8. Utilisation d'un procédé selon une des revendications précédentes pour enlever la couche de substrats qui sont revêtus de couches de carbone, les couches de carbone comprenant outre le carbone également d'autres éléments non-metalliques, en particulier l'hydrogène (H), le bore (B), le silicium (Si) et/ou le germanium (Ge).
